# EUROPÄISCHE PATENTSCHRIFT

(11) **EP 1 332 501 B1**
(45) Veröffentlichungstag und Bekanntmachung des Hinweises auf die Patenterteilung: **21.04.2004**
(21) Anmeldenummer: 01993932.1
(22) Anmeldetag: 11.10.2001
(51) Int. Cl.: G11C 17/10

(54) **SPEICHERVERWALTUNGSLOGIK ZUR ERWEITERTEN NUTZUNG VON FESTWERTSPEICHERN**
MEMORY MANAGEMENT LOGIC FOR EXPANDING THE UTILIZATION OF READ-ONLY MEMORIES
LOGIQUE DE GESTION DE MEMOIRE POUR EXPLOITATION ELARGIE DE MEMOIRES MORTES

(30) Priorität: 07.11.2000 DE 10055096
(43) Veröffentlichungstag der Anmeldung: 06.08.2003
(73) Patentinhaber: Infineon Technologies AG, 81669 München (DE)
(72) Erfinder: MAHRLA, Peter, 85604 Zorneding (DE)
(74) Vertreter: Graf Lambsdorff, Matthias, Dr.
(86) Internationale Anmeldenummer: PCT/DE2001/003891
(87) Internationale Veröffentlichungsnummer: WO 2002/039457

(56) Entgegenhaltungen:
- EP-A- 0 333 207
- EP-A- 0 419 202
- EP-A- 0 509 633
- US-A- 4 601 031
- US-A- 5 757 690
- PATENT ABSTRACTS OF JAPAN vol. 018, no. 376 (P-1770), 14. Juli 1994 (1994-07-14) & JP 06 103056 A (NEC HOME ELECTRON LTD), 15. April 1994 (1994-04-15)

## Beschreibung

Die Erfindung bezieht sich generell auf das Gebiet der Halbleiterspeicher und deren Verwaltung. Insbesondere betrifft die Erfindung dabei eine Speicherverwaltungslogik zur erweiterten Nutzung von Festwertspeichern.

Gegenwärtig werden zur Speicherung von Programmen in Mikroprozessorsystemen neben nicht-wiederbeschreibbaren Festwertspeichern (ROM) auch wiederbeschreibbare Speicher, wie z.B. RAM oder Flash-Speicher, verwendet. Festwertspeicher lassen sich im Vergleich zu wiederbeschreibbaren Speichern kostengünstig herstellen und bieten aufgrund einer einfach zu realisierenden monolithischen Integration schnellere Zugriffszeiten und somit erhöhte Arbeitsgeschwindigkeiten der Mikroprozessorsysteme. Da Festwertspeicher aus Kostengründen in der Regel über eine Maske programmiert werden, läßt sich ihr Inhalt nach der Herstellung nicht mehr verändern. Um jedoch die gespeicherten Daten auch nach der Herstellung des Speichers noch modifizieren zu können, werden anstelle der Festwertspeicher auch wiederbeschreibbare Speicher eingesetzt. Diese weisen allerdings die oben beschriebenen Nachteile gegenüber Festwertspeichern auf.

Aus Druckschrift US-A-4601031 ist ein Verfahren zum Verwalten von Speicherdaten gemäß des Oberbegriffs des Patentanspruchs 1 bekannt.

Der Erfindung liegt die Aufgabe zugrunde, die Anwendungsmöglichkeiten von Festwertspeichern zu erweitern. Insbesondere sollen Speichersysteme geschaffen werden, welche die Vorzüge von Festwertspeichern aufweisen und trotzdem die Möglichkeit der Wiederbeschreibbarkeit aufweisen.

Die der Erfindung zugrundeliegende Aufgabenstellung wird durch die Merkmale des Patentanspruchs 1 gelöst. Vorteilhafte Weiterbildungen und Ausgestaltungen sind in den Unteransprüchen angegeben.

Ein wesentlicher Gedanke der Erfindung besteht darin, einen zugriff einer Steuereinheit auf Speicherdaten, welche im wesentlichen in einem Festwertspeicher abgelegt sind, und gleichermaßen auch auf Daten, welche gegenüber den im Festwertspeicher abgelegten Daten verändert sind, zu ermöglichen. Diese veränderten Daten sind in einem wiederbeschreibbaren Speicher abgelegt. Dies kann mit einer Speicherverwaltungslogik realisiert werden, die mit einer Steuereinheit, dem Festwertspeicher und dem wiederbeschreibbaren Speicher zusammenwirkt und einen Zugriff der Steuereinheit auf vorgegebene Adressen des Festwertspeichers auf den wiederbeschreibbaren Speicher umleitet. Die durch Daten auf dem wiederbeschreibbaren Speicher ersetzten Daten des Festwertspeichers sind folglich durch die vorgegebene Adressen gekennzeichnet. Die entsprechenden Daten auf dem wiederbeschreibbaren Speicher tragen zugehörige Adressen. Greift die Steuereinheit auf die vorgegebenen Adressen des Festwertspeichers zu, so leitet die Speicherverwaltungslogik diesen Zugriff auf die zugehörigen Adressen des wiederbeschreibbaren Speichers um. Ansonsten wird auf den Festwertspeicher zugegriffen.

Durch diese Erfindung wird die Flexibilität eines Festwertspeichers erhöht, da die in dem Festwertspeicher abgelegten Daten auch nach der Herstellung des Festwertspeichers noch modifizierbar sind. Da in der Regel nur ein kleiner Teil der Speicherdaten des Festwertspeichers durch modifizierte Daten ersetzt werden soll, kann der wiederbeschreibbare Speicher eine entsprechend geringere Speicherkapazität als der Festwertspeicher besitzen. Dadurch ist diese Lösung deutlich kostengünstiger im Vergleich zu einem kompletten Austausch des Festwertspeichers durch einen wiederbeschreibbaren Speicher. Des weiteren verlangsamt sich auch wegen des verhältnismäßig geringen Anteils an Daten auf dem wiederbeschreibbaren Speicher die Zugriffsgeschwindigkeit der Steuereinheit auf die Speicherdaten nicht wesentlich. Die erfinderische Maßnahme kombiniert folglich auf neuartige Weise die Vorteile eines Festwertspeichers mit der Möglichkeit, die im Speicher abgelegten Daten modifizieren zu können.

Vorzugsweise hat die Speicherverwaltungslogik zu dem oben beschriebenen Zweck Zugang zu einer Zuordnungstabelle, durch welche die vorgegebenen Adressen des Festwertspeichers den zugehörigen Adressen auf dem wiederbeschreibbaren Speicher zugeordnet sind.

Gemäß einer bevorzugten Ausführungsform der Erfindung wird die Zuordnungstabelle im wiederbeschreibbaren Speicher abgelegt. Der Vorteil dieser Maßnahme ist, daß die Zuordnungstabelle ebenfalls modifizierbar ist. So können im Bedarfsfall andere Speicherbereiche des Festwertspeichers durch Speicherbereiche des wiederbeschreibbaren Speichers ersetzt werden. Durch diese Maßnahme erhält das Speichersystem eine noch größere Flexibilität.

In vorteilhafter Weise kann die Zuordnungstabelle von dem wiederbeschreibbaren Speicher in die Speicherverwaltungslogik übertragen werden. Beispielsweise kann die Zuordnungstabelle vor Beginn einer Programmausführung in einen Registersatz der Speicherverwaltungslogik kopiert werden. Dadurch steht die Zuordnungstabelle mit einer schnellen Zugriffsgeschwindigkeit zur Verfügung und es wird eine erhöhte Zugriffsdauer auf den Speicher vermieden.

Eine bevorzugte Maßnahme der Erfindung kennzeichnet sich dadurch, daß die Adressen des Festwertspeichers und des wiederbeschreibbaren Speichers binär kodiert sind. Dieses erleichtert den Zugriff auf die Daten. Außerdem können dann vorzugsweise die Bereiche des Festwertspeichers, in denen sich die Speicherdaten mit den vorgegebenen Adressen befinden, und auch die Bereiche des wiederbeschreibbaren Speichers so gewählt werden, daß ihre Größen einer ganzzahligen Potenz der Zahl Zwei entsprechen. Diese Maßnahme dient sowohl dem schnellen Auffinden der ersetzten Speicherbereiche des Festwertspeichers als auch einer platzsparenden Anordnung der Speicherbereiche im wiederbeschreibbaren Speicher.

Eine weitere Ausführungsform der Erfindung ist dadurch gekennzeichnet, daß die Speicherverwaltungslogik binäre Komparatoren aufweist. Aufgrund dieser Maßnahme kann die Speicherverwaltungslogik als assoziativer Speicher realisiert werden. Die Aufgabe der binären Komparatoren dabei ist, die Adressen, auf welche die Steuereinheit zugreift, mit den vorgegebenen Adressen des Festwertspeichers zu vergleichen. Des weiteren kann vorgesehen sein, daß die Speicherverwaltungslogik binäre Komparatoren aufweist, welche derart ausgebildet sind, daß sie bei einem Zugriff der Steuereinheit auf vorgegebene Adressen des Festwertspeichers die vorgegebenen Adressen des Zugriffs durch die zugehörigen Adressen auf dem wiederbeschreibbaren Speicher ersetzen. Dadurch wird folglich der Zugriff auf den wiederbeschreibbaren Speicher umgeleitet. Jeder der binären Komparatoren wird zweckmäßigerweise derart ausgelegt, daß die Anzahl der Adreßbits, für die er einen Vergleich durchführt, der Größe des Speicherbereichs angepaßt werden kann.

Eine besonders bevorzugte Ausführungsform der Erfindung kennzeichnet sich dadurch, daß die Speicherverwaltungslogik in ein Speicherverwaltungssystem eingebunden ist, welches außerdem noch eine Steuereinheit, einen Festwertspeicher und einen wiederbeschreibbaren Speicher aufweist. Beispielsweise kann es sich bei der Steuereinheit um einen Mikroprozessor handeln. Dieser kann vorzugsweise zusammen mit den anderen Komponenten des Speicherverwaltungssystems auf einem gemeinsamen Substrat monolithisch integriert sein. Ein solches monolithisch integriertes System zeichnet sich durch hohe Datenverarbeitungsgeschwindigkeiten und geringe Herstellungskosten bei hohen Stückzahlen aus.

Des weiteren läßt sich das eben beschriebene Speicherverwaltungssystem in einer bevorzugten Ausführungsform der Erfindung über eine Datenschnittstelle mit einem externen, nichtflüchtigen wiederbeschreibbaren Speicher verbinden. In diesem Speicher befindet sich etwa der modifizierte Inhalt der ersetzten Bereiche des Festwertspeichers und beispielsweise auch die Zuordnungstabelle. Vor Beginn des Programmablaufs wird dieser Speicherinhalt in den internen, wiederbeschreibbaren Speicher des Speicherverwaltungssystems geladen, welcher beispielsweise ein flüchtiger, wiederbeschreibbarer Speicher sein kann. Durch diese Maßnahme steht der Inhalt des externen Speichers dem Speicherverwaltungssystem mit hoher Zugriffsgeschwindigkeit zur Verfügung. Würde andererseits der externe, nichtflüchtige wiederbeschreibbare Speicher als der wiederbeschreibbare Speicher des Speicherverwaltungssystems fungieren, so würde eine große Zahl von Adreß- und Datenpins benötigt, um die gleiche Zugriffsgeschwindigkeit wie bei der oben beschriebenen bevorzugten Ausführungsform zu erzielen. Aufgrund der demgegenüber geringeren Zahl von Adreß- und Datenpins werden bei der bevorzugten Ausführungsform die Kosten für die Herstellung des monolithischen Bausteins drastisch reduziert. Außerdem wird dadurch die Verdrahtung auf der Platine des Endgeräts in erheblichem Umfang verringert und damit auch eine kleinere Baugröße des Endgeräts erzielt.

Das erfindungsgemäße Verfahren zur Verwaltung von Speicherdaten, bei welchem Speicherdaten im wesentlichen in einem Festwertspeicher abgelegt sind, ist durch folgende Schritte gekennzeichnet:
- Im Bedarfsfall wird in einem wiederbeschreibbaren Speicher ein Speicherbereich erzeugt, welcher einen Speicherbereich des Festwertspeichers ersetzen soll.
- Bei einem Zugriff auf Speicherdaten des ersetzten Speicherbereichs erfolgt eine Umleitung zu dem entsprechenden Speicherbereich des wiederbeschreibbaren Speichers.

Gemäß diesem Verfahren befinden sich im allgemeinen die Speicherdaten auf einem Festwertspeicher und können von dort mit nur geringem Zeitaufwand abgefragt werden. Allerdings lassen sich die auf dem Festwertspeicher abgespeicherten Daten nicht direkt überschreiben. Ist jedoch eine Abänderung der dort gespeicherten Daten notwendig, so wird ein Speicherbereich in einem wiederbeschreibbaren Speicher geschaffen und die Daten, welche die Daten bestimmter Speicherbereiche des Festwertspeichers ersetzen sollen, werden in dem wiederbeschreibbaren Speicher abgelegt. Erfolgt ein Zugriff auf ersetzte Bereiche des Festwertspeichers, so wird dieser Zugriff auf den entsprechenden Bereich des wiederbeschreibbaren Speichers umgeleitet. Das erfindungsgemäße Verfahren ermöglicht es folglich, Speicherdaten auf flexible Weise zu verwalten, so daß die auf dem Festwertspeicher abgelegten Daten in einem gewissen Maße modifizierbar gemacht werden. Dieses ist aufgrund der nur gelegentlich notwendigen Umleitung des Zugriffs mit nur geringen Einbußen in der Zugriffsdauer verbunden.

In einer bevorzugten Ausführungsform des erfindungsgemäßen Verfahrens erfolgt der Zugriff auf die Speicherdaten durch eine Steuereinheit. Dieses kann beispielsweise ein Mikroprozessor sein.

Eine besonders bevorzugte Ausführungsform ist dadurch gekennzeichnet, daß die Adressen des Festwertspeichers und des wiederbeschreibbaren Speichers binär kodiert sind. Des weiteren werden bei dieser besonders bevorzugten Ausführungsform bei einem Zugriff der Steuereinheit auf Adressen des Festwertspeichers, welche in einem ersetzten Bereich liegen, nur die Bits der Adressen durch die Bits der Adressen des entsprechenden Bereichs auf dem wiederbeschreibbaren Speicher ersetzt, die für alle Adressen dieses ersetzten Bereichs gleich sind. Ein Vorteil dieses Verfahrens ist, daß nur so viele der am Anfang der Adressen stehenden Bits gelesen werden müssen, bis die Bits erreicht sind, die für alle Adressen des ersetzten Bereichs gleich sind. Durch diese Maßnahme wird die Zeit minimiert, die notwendig ist, um die Adressen, auf die zugegriffen wird, mit den Adressen der ersetzten Speicherbereiche abzugleichen. Ein weiterer Vorteil dieser besonders bevorzugten Ausführungsform liegt darin, daß bei einer Umleitung des Zugriffs auf den wiederbeschreibbaren Speicher lediglich die vorderen Bits der ursprünglichen Adressen durch die Bits der Adressen des wiederbeschreibbaren Speichers ausgetauscht werden müssen. Vorzugsweise läßt sich diese besonders bevorzugte Ausführungsform durch binäre Komparatoren realisieren. Diese vergleichen die Adressen, auf die zugegriffen wird, mit den Adressen der ersetzten Speicherbereiche des Festwertspeichers und ersetzen die Adressen im Bedarfsfall durch die Adressen des entsprechenden Bereichs des wiederbeschreibbaren Speichers.

Ein weitere Ausführungsform des erfindungsgemäßen Verfahrens sieht vor, daß ein Zugriff der Steuereinheit zunächst an den beim vorhergehenden Zugriff genutzten Speicher weitergeleitet wird. Falls dieser Zugriff in den wiederbeschreibbaren Speicher erfolgte, werden für die Adresse des erneuten Zugriffs die am Anfang der Adresse des vorhergehenden Zugriffs stehenden Bits verwendet. Nur sofern bei zwei aufeinanderfolgenden Zugriffen auf den Speicher ein Wechsel zwischen dem Festwertspeicher und dem wiederbeschreibbaren Speicher oder zwischen zwei verschiedenen Bereichen des wiederbeschreibbaren Speichers erforderlich ist, wird das vom Speicher zurückgegebene Datum nicht an die Steuereinheit weitergegeben. Ausschließlich in diesem Fall verzögert sich der Speicherzugriff, da ein nochmaliger Zugriff auf den richtigen Speicher erfolgen muß. Bezogen auf die Gesamtzahl der Speicherzugriffe ist die Anzahl der Wechsel in der Regel jedoch vernachlässigbar, so daß dadurch die mittlere Zugriffszeit nur geringfügig erhöht wird.

Beispielsweise kann die Regelung der Datenweitergabe an die Steuereinheit über das READY und WAIT-Signal erfolgen. Dieses Signal, über welches die meisten Mikroprozessoren verfügen, zeigt dem Mikroprozessor an, ob schon ein gültiges Datum auf den Datenleitungen zur Verfügung steht. Im Falle eines fehlerhaften Erstzugriffs auf den Speicher wird das Datum für den Mikroprozessor gesperrt. Erst nach dem zweiten, richtigen Zugriff wird das Datum für den Mikroprozessor zum Lesen freigegeben.

Die Erfindung wird nachfolgend anhand von drei Ausführungsbeispielen unter Bezugnahme auf die Zeichnungen näher erläutert; in diesen zeigen:
- Fig. 1: ein Blockschaltbild eines Speicherverwaltungssystems in einer ersten Ausführungsform;
- Fig. 2: ein Blockschaltbild eines Speicherverwaltungssystems in einer zweiten Ausführungsform; und
- Fig. 3: eine schematische Darstellung der Speicherbereiche eines Festwertspeichers und eines wiederbeschreibbaren Speichers und deren Zuordnung.

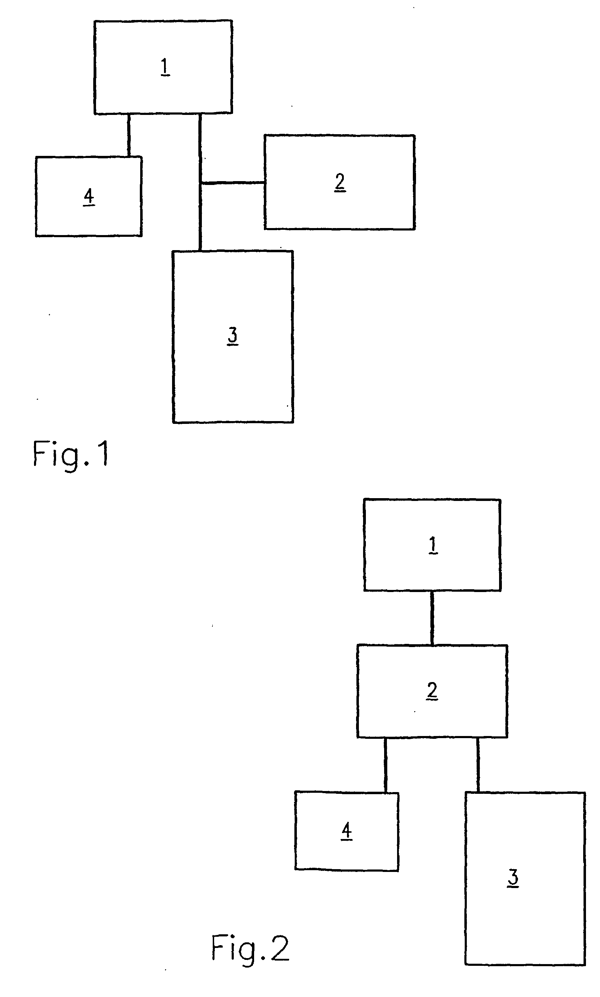

Fig. 1 zeigt das Blockschaltbild einer ersten erfindungsgemäßen Ausführungsform eines Speicherverwaltungssystems. Eine Steuereinheit 1 steht dabei in Verbindung mit einem Festwertspeicher 3 und einem wiederbeschreibbaren Speicher 4. Außerdem kontrolliert eine Speicherverwaltungslogik 2 den Zugriff der Steuereinheit 1 auf die Daten des Festwertspeichers 3 und auch den Datenfluß vom Festwertspeicher 3 zu der Steuereinheit 1.

Manche Daten des Festwertspeichers 3 sind in diesem Speicherverwaltungssystem ersetzt worden durch Daten auf dem wiederbeschreibbaren Speicher 4. Falls die Steuereinheit 1 Daten mit auf dem Festwertspeicher 3 befindlichen Adressen anfordert, prüft die Speicherverwaltungslogik 2, ob diese Adressen zu den Daten gehören, die durch Daten auf dem wiederbeschreibbaren Speicher 4 ersetzt wurden. Trifft dieses zu, sperrt die Speicherverwaltungslogik 2 den Datenfluß vom Festwertspeicher 3 zur Steuereinheit 1 und leitet statt dessen den Zugriff auf den wiederbeschreibbaren Speicher 4 um. Dazu werden die Adressen des ursprünglichen Zugriffs durch die Adressen des entsprechenden Bereichs des wiederbeschreibbaren Speichers 4 ersetzt.

Um erkennen zu können, welche Speicherbereiche des Festwertspeichers 3 durch Speicherbereiche des wiederbeschreibbaren Speichers 4 ersetzt wurden, hat die Speicherverwaltungslogik 2 beispielsweise Zugang zu einer Zuordnungstabelle, in welcher die Zuordnung der ersetzten Bereiche des Festwertspeichers 3 mit den entsprechenden Bereichen des wiederbeschreibbaren Speichers 4 aufgelistet ist. Diese Zuordnungstabelle wird üblicherweise in dem wiederbeschreibbaren Speicher 4 abgelegt und von dort vor der Ausführung des Anwendungsprogramms in die Speicherverwaltungslogik 2 geladen. Dort steht sie dann mit hoher Zugriffsgeschwindigkeit zur Verfügung.

Es ist auch denkbar, daß die Steuereinheit 1 dieses Ausführungsbeispiels so ausgelegt ist, daß ihr Zugriff auf Speicherdaten immer auf den Speicher erfolgt, der beim vorhergehenden Zugriff genutzt wurde. In diesem Fall gibt die Steuereinheit 1 die Information an die Speicherverwaltungslogik 2 weiter, auf welchen Speicher und auf welche Adressen der Zugriff erfolgt. Die Speicherverwaltungslogik 2 gleicht daraufhin die Adressen des Zugriffs mit denen der Zuordnungstabelle ab. Falls der Zugriff der Steuereinheit 1 auf den falschen Speicher erfolgt, verhindert die Speicherverwaltungslogik 2 jegliche Datenweitergabe an die Steuereinheit 1, bis der Zugriff auf den richtigen Speicher erfolgt ist. Ausschließlich bei einem solchen fehlerhaften Erstzugriff verzögert sich die Zugriffsdauer auf die Speicherdaten. Da jedoch im allgemeinen der wiederbeschreibbare Speicher 4 wesentlich weniger Daten als der Festwertspeicher 3 aufweist, tritt der eben beschriebene Fall relativ selten ein. Daher verzögert sich die Zugriffsdauer auf die Speicherdaten im Mittel nur unwesentlich.

In einer möglichen Ausführungsform des in Fig. 1 dargestellten Speicherverwaltungssystems ist die Steuereinheit 1 ein Mikroprozessor, der Festwertspeicher 3 steht für ein ROM und der wiederbeschreibbare Speicher 4 kann durch einen RAM realisiert werden. Die Speicherverwaltungslogik 2 kann dabei sowohl in einer Logikschaltung, insbesondere einer festverdrahteten Schaltung, vorliegen, als auch rein softwaremäßig als Computerprogramm implementiert werden.

Sofern die Steuereinheit 1 ein Mikroprozessor ist, kann die Speicherverwaltungslogik 2 die Datenweitergabe an den Mikroprozessor bei einem fehlerhaften Zugriff auf den Speicher zweckmäßigerweise über das READY und WAIT-Signal sperren. Entsprechend kann bei einem gültigen Zugriff der Datentransfer vom jeweiligen Speicher zum Mikroprozessor über das READY und WAIT-Signal freigegeben werden.

In Fig. 2 ist das Blockschaltbild einer weiteren Ausführungsform eines Speicherverwaltungssystems dargestellt. Ein entscheidender Unterschied dieses Ausführungsbeispiels zu dem in Fig. 1 dargestellten Ausführungsbeispiel besteht darin, daß hier die Speicherverwaltungslogik 2 seriell zwischen die Steuereinheit 1 und den Festwertspeicher 3 bzw. den wiederbeschreibbaren Speicher 4 geschaltet ist. Alle Zugriffe der Steuereinheit 1 auf Speicherdaten laufen folglich über die Speicherverwaltungslogik 2 und werden von dort an einen der beiden Speicher weitergeleitet.

Hierbei kann vorgesehen sein, daß die Speicherverwaltungslogik 2 jeden Zugriff der Steuereinheit 1 auf Speicherdaten zunächst an den Speicher weiterleitet, der beim vorhergehenden Zugriff genutzt wurde. Handelt es sich jedoch um den falschen Speicher, so verhindert die Speicherverwaltungslogik 2 die Datenweitergabe von diesem Speicher an die Steuereinheit 1 und leitet den Zugriff auf den richtigen Speicher um. Ansonsten kann dieses Ausführungsbeispiel die gleichen Merkmale wie das in Fig. 1 dargestellte Ausführungsbeispiel aufweisen.

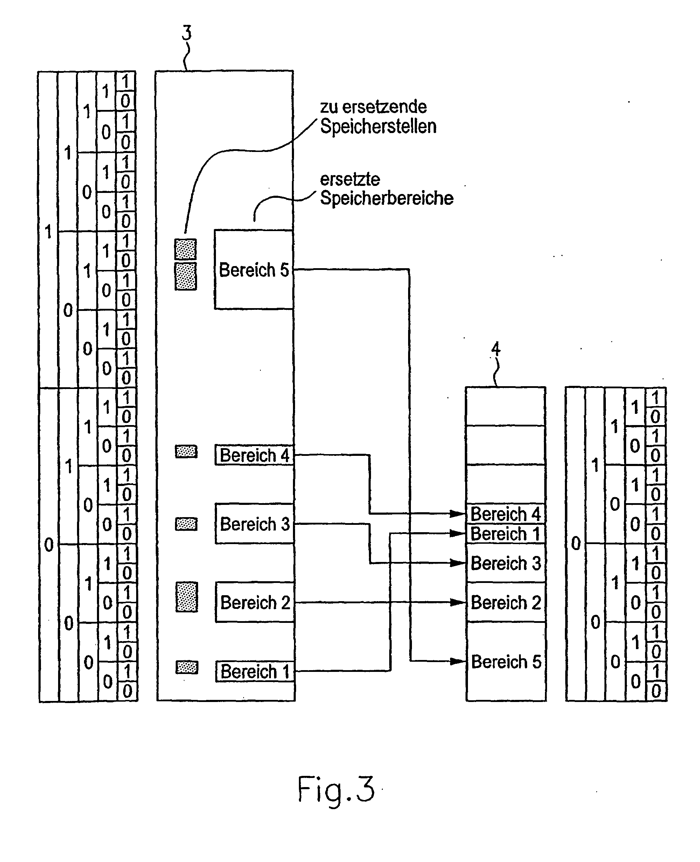

In Fig. 3 sind schematisch die Speicherbereiche eines Festwertspeichers 3 und eines wiederbeschreibbaren Speichers 4 und die Zuordnung der ersetzten Speicherbereiche des Festwertspeichers 3 mit den entsprechenden Speicherbereichen des wiederbeschreibbaren Speichers 4 gezeigt.

Sowohl die Adressen des Festwertspeichers 3 als auch die des wiederbeschreibbaren Speichers 4 sind in diesem Ausführungsbeispiel binär kodiert. Aufgrund der binären Kodierung können die Bereiche des Festwertspeichers 3, die durch Bereiche auf dem wiederbeschreibbaren Speicher 4 ersetzt werden sollen, so gewählt werden, daß ihre Größe einer ganzzahligen Potenz der Zahl Zwei entspricht. Die ersetzten Speicherbereiche müssen dabei so gewählt werden, daß sie die jeweiligen zu ersetzenden Speicherstellen des Festwertspeichers 3 vollständig beinhalten. Als Beispiel sei der Bereich 5 des Festwertspeichers 3 gewählt. Dieser Bereich beinhaltet die Adressen 101xy (mit x, y = 0, 1). Zugleich ist dieser Bereich - bei der gewählten Kodierung - die kleinstmögliche Einheit, um die in diesem Bereich liegenden, zu ersetzenden Speicherstellen zu umfassen. Dieses Vorgehen ist insofern von Vorteil, als daß die ersetzten Bereiche des Festwertspeichers 3 schneller gefunden werden können. Gleichzeitig können dadurch auch die Speicherbereiche im wiederbeschreibbaren Speicher 4 platzsparend angeordnet werden.

Des weiteren bietet die binäre Kodierung der Adressen beider Speicher den Vorteil, daß bei einem Zugriff auf ersetzte Bereiche des Festwertspeichers 3 nur die Bits der Adressen durch die zugehörigen Bits der Adressen auf dem wiederbeschreibbaren Speicher 4 ersetzt werden müssen, welche für alle Adressen des ausgewählten Bereichs gleich sind. Im oben angeführten Beispiel des Bereichs 5 würden die ursprünglichen Adressen 101xy durch 000xy ersetzt werden, d.h. die letzten beiden Bits würden bei jeder der Adressen erhalten bleiben, denn es sind diejenigen Bits, in denen sich die Adressen des ersetzten Bereichs 5 unterscheiden.

Die soeben beschriebene Aufgabe, die Adressen bei einem Zugriff gegebenenfalls zu ersetzen, könnten binäre Komparatoren wahrnehmen. Die binären Komparatoren müßten zunächst die Adressen, auf die zugegriffen wird, mit den Adressen der ersetzten Bereiche des Festwertspeichers 3 vergleichen und anschließend im Bedarfsfall die entsprechenden Bits der Adressen des Zugriffs ersetzen.

Die Zuordnung der ersetzten Bereiche des Festwertspeichers 3 mit den entsprechenden Bereichen des wiederbeschreibbaren Speichers 4 ist in Fig. 3 durch Pfeile dargestellt. Vorzugsweise wird diese Zuordnung in eine Zuordnungstabelle übertragen. Die Zuordnungstabelle kann beispielsweise auch in dem wiederbeschreibbaren Speicher 4 gespeichert sein und wird vor Beginn des Programmablaufs in die Speicherverwaltungslogik 2 geladen, damit sie mit hoher Zugriffsgeschwindigkeit zur Verfügung steht.

## Patentansprüche

1. Verfahren zum Verwalten von Speicherdaten, bei welchem Speicherdaten im wesentlichen in einem Festwertspeicher (3) abgelegt sind, und
- im Bedarfsfall in einem wiederbeschreibbaren Speicher (4) ein Speicherbereich erzeugt wird, welcher einen Speicherbereich des Festwertspeichers (3) ersetzen soll, und
- bei einem Zugriff auf Speicherdaten des ersetzten Speicherbereichs eine Umleitung zu dem entsprechenden Speicherbereich des wiederbeschreibbaren Speichers (4) erfolgt,
**dadurch gekennzeichnet, daß**
(a) ein aktueller Zugriff auf Speicherdaten zunächst an den beim vorhergehenden Zugriff genutzten Speicher weitergeleitet wird, und daß
(b) falls zwischen einem aktuellen und einem vorhergehenden Zugriff ein Wechsel zwischen dem Festwertspeicher (3) und dem wiederbeschreibbaren Speicher (4) oder zwischen zwei Bereichen des wiederbeschreibbaren Speichers (4) erforderlich ist, so wird das von dem im Verfahrensschritt (a) adressierten Speicher zurückgegebene Datum nicht verwendet, und
anschließend der aktuelle Zugriff erneut an den richtigen Speicher weitergeleitet, und
(c) falls zwischen einem aktuellen und einem vorhergehenden Zugriff kein Wechsel zwischen dem Festwertspeicher (3) und dem wiederbeschreibbaren Speicher (4) oder zwischen zwei Bereichen des wiederbeschreibbaren Speichers (4) erforderlich ist, so wird das von dem im Verfahrensschritt (a) adressierten Speicher zurückgegebene Datum verwendet.

2. Verfahren nach Anspruch 1,
**dadurch gekennzeichnet, daß**
- der Zugriff auf Speicherdaten durch eine Steuereinheit (1) erfolgt.

3. Verfahren nach Anspruch 1 oder 2,
**dadurch gekennzeichnet, daß**
- die Adressen des Festwertspeichers (3) und des wiederbeschreibbaren Speichers (4) binär kodiert sind, und
- bei einem Zugriff auf Speicherdaten eines ersetzten Speicherbereichs des Festwertspeichers (3) nur die Bits der Adressen, welche für alle Adressen des ersetzten Speicherbereichs gleich sind, durch die Bits der Adressen des entsprechenden Speicherbereichs des wiederbeschreibbaren Speichers (4) ersetzt werden.

4. Verfahren nach Anspruch 1,
**dadurch gekennzeichnet, daß**
- bei einem Zugriff auf Speicherdaten binäre Komparatoren die Adressen, auf die zugegriffen wird, mit den Adressen der ersetzten Speicherbereiche des Festwertspeichers (3) vergleichen, und
- die binären Komparatoren im Bedarfsfall die Adressen, auf die zugegriffen wird, durch die Adressen des entsprechenden Bereichs des wiederbeschreibbaren Speichers (4) ersetzen.

5. Verfahren nach den Ansprüchen 1 und 2,
**dadurch gekennzeichnet, daß**
- die Datenweitergabe an die Steuereinheit (1) mittels eines READY und WAIT-Signals freigegeben bzw. gesperrt wird.

## Claims

1. A method for managing stored data in which stored data are stored essentially in a read-only memory (3), and
- if required, a memory area intended to replace a memory area of the read-only memory (3) is produced in a rewriteable memory (4), and
- access to stored data in the replaced memory area involves a diversion being made to the corresponding memory area of the rewriteable memory (4),
**characterized in that**
(a) current access to stored data is first forwarded to the memory used for the previous access, and **in that**
(b) if a change between the read-only memory (3) and the rewriteable memory (4) or between two areas of the rewriteable memory (4) is necessary between a current access operation and a previous access operation, the data item returned by the memory addressed in method step (a) is not used, and the current access is then forwarded to the correct memory again, and
(c) if no change between the read-only memory (3) and the rewriteable memory (4) or between two areas of the rewriteable memory (4) is necessary between a current access operation and a previous access operation, the data item returned by the memory addressed in method step (a) is used.

2. The method as claimed in claim 1,
**characterized in that**
- stored data are accessed by a control unit (1).

3. The method as claimed in claim 1 or 2,
**characterized in that**
- the addresses in the read-only memory (3) and in the rewriteable memory (4) are in binary-coded form, and
- access to stored data in a replaced memory area of the read-only memory (3) involves only the bits of the addresses which are the same for all addresses in the replaced memory area being replaced with the bits of the addresses in the corresponding memory area of the rewriteable memory (4).

4. The method as claimed in claim 1,
**characterized in that**
- access to stored data involves binary comparators comparing the addresses accessed with the addresses in the replaced memory areas of the read-only memory (3), and
- the binary comparators, if required, replace the addresses accessed with the addresses in the corresponding area of the rewriteable memory (4).

5. The method as claimed in claims 1 and 2,
**characterized in that**
- data forwarding to the control unit (1) is enabled and disabled using the READY and WAIT signal.

## Revendications

1. Procédé de gestion de données de mémoire dans lequel des données de mémoire sont mises pour l'essentiel dans une mémoire (3) morte et
- en cas de besoin, on produit dans une mémoire (4) qui peut être régénérée une zone de mémoire qui doit remplacer une zone de mémoire de la mémoire (3) morte ; et
- lors d'un accès à des données de mémoire de la zone de mémoire remplacée, on passe à la zone de mémoire correspondante de la mémoire (4) qui peut être régénérée ;
**caractérisé en ce que**
(a) on transmet un accès présent à des données de mémoire d'abord à la mémoire utilisée lors de l'accès précédent et **en ce que**
(b) dans le cas où, entre un accès présent et un accès précédent, est nécessaire un échange entre la mémoire (3) morte et la mémoire (4) qui peut être régénérée ou entre deux zones de la mémoire (4) qui peut être régénérée, on n'utilise pas la donnée rendue par la mémoire adressée au stade (a) du procédé, et
ensuite, on transmet l'accès présent à nouveau à la bonne mémoire; et
(c) dans le cas où, entre un accès présent et un accès précédent, un échange entre la mémoire (3) morte et la mémoire (4) qui peut être régénérée ou entre deux parties de la mémoire (4) qui peut être régénérée est nécessaire, on utilise la donnée rendue par la mémoire adressée au stade (a) du procédé.

2. Procédé suivant la revendication 1, **caractérisé en ce que** l'accès aux données de la mémoire s'effectue par une unité (1) de commande.

3. Procédé suivant la revendication 1 ou 2, **caractérisé en ce que**
- les adresses de la mémoire (3) morte et de la mémoire (4) qui peut être régénérée sont codées en binaires ; et
- pour un accès à des données de mémoire d'une zone de mémoire remplacée de la mémoire (3) morte, on ne remplace que les binaires des adresses qui sont les mêmes pour toutes les adresses de la zone de mémoire remplacée par les binaires des adresses de la zone de mémoire correspondante de la mémoire (4) qui peut être régénérée.

4. Procédé suivant la revendication 1, **caractérisé en ce que**
- pour un accès à des données de mémoire de comparateurs binaires, on compare les adresses auxquelles on a accès aux adresses des zones de mémoire remplacées de la mémoire (3) morte ; et
- les comparateurs binaires remplacent en cas de besoin les adresses auxquelles on a accès par les adresses de la zone correspondante de la mémoire (4) qui peut être régénérée.

5. Procédé suivant les revendications 1 et 2, **caractérisé en ce que** la transmission des données à l'unité (1) de commande est autorisée ou empêchée au moyen d'un signal READY et WAIT.
